# EUROPEAN PATENT APPLICATION

(11) **EP 4 608 088 A1**
(43) Date of publication of application: **27.08.2025**
(21) Application number: 24194124.4
(22) Date of filing: 12.08.2024
(51) Int. Cl.: H10D 30/47, H10D 30/01, H10D 64/00, H10D 62/10, H10D 62/53, H10D 62/17, H10D 64/23, H10D 62/85

(54) **SEMICONDUCTOR DEVICE**

(30) Priority: 20.02.2024 KR 20240024432
(71) Applicant: Samsung Electronics Co., Ltd, Suwon-si, Gyeonggi-do 16677 (KR)
(72) Inventor: KIM, Joonyong, Suwon-si (KR); HWANG, In Jun, Suwon-si (KR); KIM, Sanghyun, Suwon-si (KR); YANG, Seong Seok, Suwon-si (KR)
(74) Representative: Marks & Clerk LLP

(57) **Abstract**

A semiconductor device includes a channel layer (132) including a channel suppression region (CRA), a barrier layer (136) positioned above the channel layer and including a material having an energy band gap different from the channel layer, a gate electrode (155) positioned above the barrier layer, a protective layer (140) positioned above the gate electrode, a source electrode (173) and drain electrode (175) positioned on both sides of the gate electrode and connected to the channel layer, and a field dispersion layer (177) positioned on the protective layer, protruded from an edge adjacent to the drain electrode toward the drain electrode, and including a protrusion portion (177a) adjacent to the channel suppression region.

## Description

### TECHNICAL FIELD

The invention generally relates to a semiconductor device.

### BACKGROUND

In modern society, semiconductor devices are closely related to daily life. In particular, the importance of power semiconductor devices used in various fields such as transportation fields such as electric vehicles, railways, and electric trams, renewable energy systems such as solar power generation and wind power generation, and mobile devices is gradually increasing. A power semiconductor device is a semiconductor device used to handle high voltage or high current, and performs functions such as electric power conversion and control in large electric power systems or high power electronic devices. Power semiconductor devices have the ability to handle high electric power and durability, thereby handling large amounts of current and withstanding high voltages. For example, a power semiconductor device may handle voltages of hundreds to thousands of volts and currents of tens of amperes to thousands of amperes. Power semiconductor devices may improve the efficiency of electrical energy by reducing power loss. Additionally, power semiconductor devices may be operated stably even in environments such as high temperature. These power semiconductor devices may be classified according to material, and for example, there are SiC power semiconductor devices and GaN power semiconductor devices. By manufacturing power semiconductor devices using SiC or GaN instead of existing silicon wafers (Si wafers), the drawbacks of silicon, which has unstable characteristics at high temperatures, may be compensated. SiC power semiconductor devices are resistant to high temperatures and have low power loss, and may be suitable for electric vehicles, renewable energy systems, etc. GaN power semiconductor devices may be expensive, but are efficient in terms of speed and may be suitable for high-speed charging of mobile devices.

### SUMMARY

The invention is a semiconductor device as defined by claim 1. Preferred embodiments are defined by the dependent claims.

According to some implementations, the present disclosure is directed to a semiconductor device that includes a channel layer including a channel suppression region, a barrier layer positioned above the channel layer and including a material having an energy band gap different from the channel layer, a gate electrode positioned above the barrier layer, a protective layer positioned above the gate electrode, a source electrode and drain electrode positioned on both sides of the gate electrode and connected to the channel layer, and a field dispersion layer positioned on the protective layer, protruded from an edge adjacent to the drain electrode toward the drain electrode, and including a protrusion portion adjacent to the channel suppression region.

According to some implementations, the present disclosure is directed to a semiconductor device that includes a channel layer containing GaN, a barrier layer positioned above the channel layer and containing AlGaN, a gate electrode positioned above the barrier layer, a protective layer positioned above the gate electrode, a source electrode and a drain electrode positioned on both sides of the gate electrode and connected to the channel layer, and a field dispersion layer positioned on the protective layer and connected to the source electrode, a two-dimensional electron gas is formed between the source electrode and the drain electrode within the channel layer, the channel layer includes a channel suppression region in which the two-dimensional electron gas is suppressed, and the field dispersion layer includes a protruding portion that overlaps the channel suppression region in the vertical direction on the upper surface of the channel layer.

According to some implementations, the present disclosure is directed to a semiconductor device that includes a channel layer including GaN, a barrier layer positioned above the channel layer and containing AlGaN, a gate electrode positioned above the barrier layer, a protective layer positioned above the gate electrode, a source electrode and a drain electrode positioned on both sides of the gate electrode and connected to the channel layer, and a field dispersion layer positioned on the protective layer and connected to the source electrode, a two-dimensional electron gas is formed between the source electrode and the drain electrode within the channel layer, the channel layer includes a channel suppression region in which the two-dimensional electron gas is suppressed, an edge of the field dispersion layer adjacent to the drain electrode overlaps the channel suppression region, and the channel suppression region overlaps a doping region containing Ar or N within the barrier layer, or overlaps a recess from which the barrier layer was removed.

### BRIEF DESCRIPTION OF THE DRAWINGS

Example implementations will be clearly understood from the following detailed description, taken in conjunction with the accompanying drawings.
FIG. 1 is a plan view showing an example of a semiconductor device according to some implementations.
FIG. 2 is a plan view showing an enlarged view of an example of an AR1 region in FIG. 1 according to some implementations.
FIG. 3 is a cross-sectional view shown along line III-IIF in FIG. 1 according to some implementations.
FIG. 4 is a cross-sectional view shown along line IV-IV' in FIG. 1 according to some implementations.
FIG. 5 is a plan view showing an example of a semiconductor device according to some implementations.
FIG. 6 is an enlarged plan view of an example of a AR2 region in FIG. 5 according to some implementations.
FIG. 7 is a cross-sectional view shown along line VII-VII' in FIG. 5 according to some implementations.
FIG. 8 is a cross-sectional view showing an example of a semiconductor device according to some implementations.
FIG. 9 is a cross-sectional view showing an example of a semiconductor device according to some implementations.
FIG. 10 is a cross-sectional view showing an example of a semiconductor device according to some implementations.
FIG. 11 is a cross-sectional view showing an example of a semiconductor device according to some implementations.
FIG. 12 is a cross-sectional view showing an example of a semiconductor device according to some implementations.
FIG. 13 and FIG. 14 are a plan view showing an example of a semiconductor device according to some implementations.
FIG. 15 is a plan view showing an example of a semiconductor device according to some implementations.
FIG. 16 is a cross-sectional view shown along line XVI-XVI' in FIG. 15 according to some implementations.
FIG. 17 is a plan view showing an example of a semiconductor device according to some implementations.
FIG. 18 is a cross-sectional view shown along line XVIII-XVIII' in FIG. 17 according to some implementations.
FIG. 19 is a cross-sectional view shown along line XIX-XIX' in FIG. 17 according to some implementations.

### DETAILED DESCRIPTION

Hereinafter, example implementations will be explained in detail with reference to the accompanying drawings. In order to clearly describe the present disclosure, parts irrelevant to the description are omitted, and the same reference numerals are assigned to the same or similar constituent element throughout the specification. In addition, since the size and thickness of each component shown in the drawings are arbitrarily shown for better understanding and ease of description, the present disclosure is not necessarily limited to that which is shown. In the drawings, the thickness of layers, films, panels, regions, etc., are exaggerated for clarity. Additionally, in the drawings, for convenience of explanation, the thicknesses of some layers and regions are exaggerated.

In addition, it will be understood that when an element such as a layer, film, region, or substrate is referred to as being "on" another element, it may be directly on the other element or intervening elements may also be present. In contrast, when an element is referred to as being "directly on" another element, it means that there is no other part in between. In addition, being "above" or "on" a reference part means being located above or below the reference part, and does not necessarily mean being located "above" or "on" it in the opposite direction of gravity.

In addition, unless explicitly described to the contrary, the word "comprise", and variations such as "comprises" or "comprising", will be understood to imply the inclusion of stated elements but not the exclusion of any other elements. In addition, the phrase "on a plane" means when an object portion is viewed from above, and the phrase "on a cross-section" means when a cross-section taken by vertically cutting an object portion is viewed from the side.

We further note, throughout this specication, any reference to a direction, e.g., "perpendicular" may mean exactly, substantially, or approximately. Similarly, a distance value such as 0.1µm, 2µm, 0.05µm or 5µm may mean exactly, substantially or approximately that value. Similarly again, a shape descriptor, such as circular, quadrangle, triangle, or round, may mea exactly, substantially or approximately that shape.

In general, in some aspects, the present disclosure is directed toward semiconductor devices having stable electric characteristics and/or improved reliability.

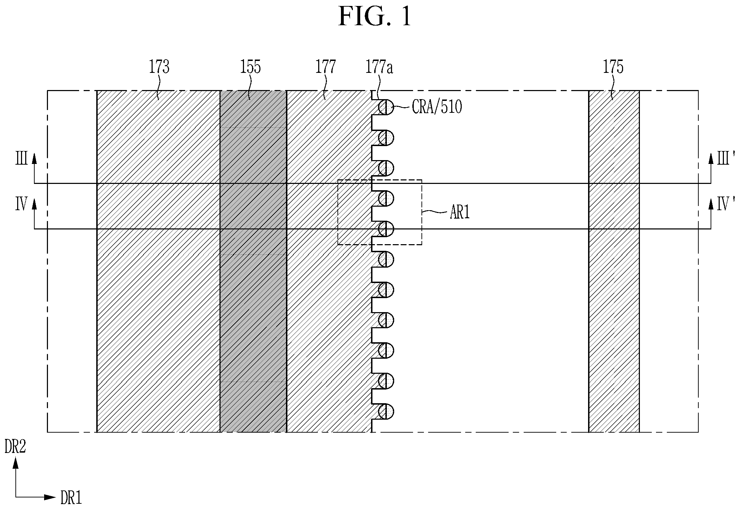

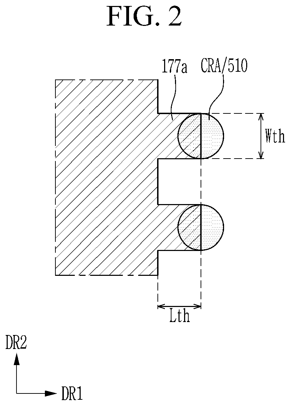

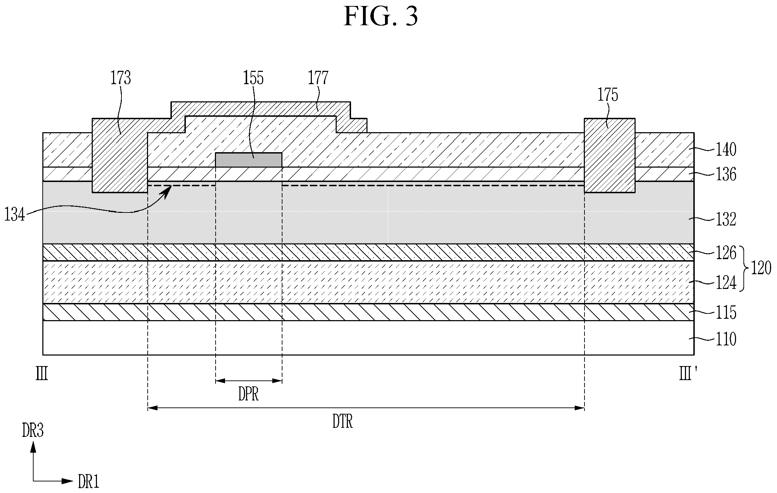

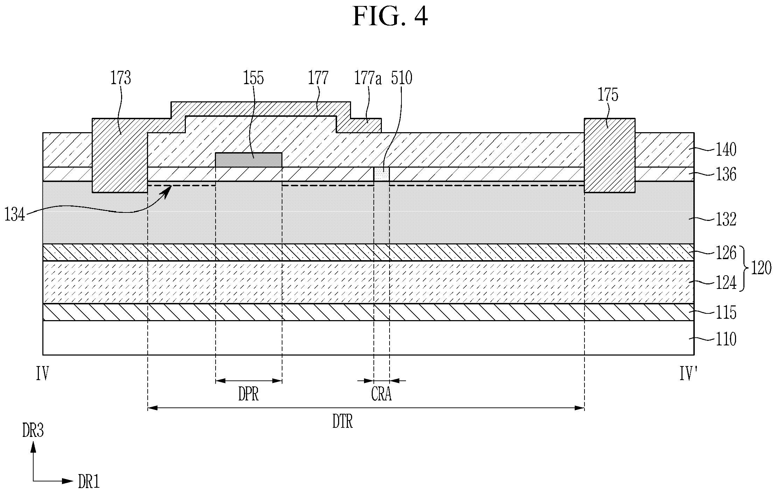

FIG. 1 is a plan view showing an example of a semiconductor device according to some implementations, and FIG. 2 is a plan view showing an enlarged view of an example of a AR1 region in FIG. 1 according to some implementations. FIG. 3 is a cross-sectional view shown along line III-III' in FIG. 1 according to some implementations, and FIG. 4 is a cross-sectional view shown along line IV-IV' in FIG. 1 according to some implementations.

In FIGS. 1 to 4, a semiconductor device may include a channel layer 132, a barrier layer 136 positioned above the channel layer 132, a gate electrode 155 positioned above the barrier layer 136, a protective layer 140 positioned above the gate electrode 155, a source electrode and a drain electrode positioned on both sides of the gate electrode 155 and connected to the channel layer 132, and a field dispersion layer 177 positioned on the protective layer 140.

The channel layer 132 is a layer that forms a channel between the source electrode 173 and the drain electrode 175, and a two-dimensional electron gas (2DEG, 2-dimensional electron gas) 134 may be positioned inside the channel layer 132. The two-dimensional electron gas 134 is a charge transport model and refers to a group of electrons tightly bound within two dimensions where they may move freely in two dimensions (e.g., x-y planar direction) but may not move in another dimension (e.g., in z direction). That is, the two-dimensional electron gas 134 may exist in a two-dimensional paper-like form within a three-dimensional space. This two-dimensional electron gas 134 mainly appears in a semiconductor heterojunction structure, and may occur at an interface between the channel layer 132 and the barrier layer 136 in a semiconductor device according to an embodiment. For example, the two-dimensional electron gas 134 may be generated in a portion closest to the barrier layer 136 within the channel layer 132.

The channel layer 132 may include one or more materials selected from Group III-V materials, for example, nitrides containing at least one of Al, Ga, In, and B. The channel layer 132 may be made of a single layer or multiple layers. The channel layer 132 may be AlxInyGa1-x-yN (0≤x≤1, 0≤y≤1, x+y≤1). For example, the channel layer 132 may include at least one of AlN, GaN, InN, InGaN, AlGaN, AlInN, and AlInGaN. The channel layer 132 may be a layer doped with impurities or a layer undoped with impurities. A thickness of the channel layer 132 may be about several hundred nm or less.

The channel layer 132 may be positioned on a substrate 110, and a seed layer 115, a buffer layer 120, etc. may be positioned between the substrate 110 and the channel layer 132. The substrate 110, the seed layer 115, and the buffer layer 120 are layers optionally used to form the channel layer 132 and may be omitted in some implementations. For example, when a substrate made of GaN is used as the channel layer 132, at least one of the substrate 110, the seed layer 115, and the buffer layer 120 may be omitted. Considering that the price of a substrate made of GaN is relatively high, the channel layer 132 containing GaN may be grown using the substrate 110 made of Si. At this time, since the lattice structure of Si and the lattice structure of GaN are different, it may not be easy to grow the channel layer 132 directly on the substrate 110. Accordingly, the seed layer 115 and the buffer layer 120 may be first grown on the substrate 110, and then the channel layer 132 may be grown on the buffer layer 120. Additionally, at least one of the substrate 110, the seed layer 115, and the buffer layer 120 may be removed from the final structure of the semiconductor device after being used in the manufacturing process.

The substrate 110 may include a semiconductor material. For example, the substrate 110 may include sapphire, Si, SiC, AlN, GaN, or a combination thereof. The substrate 110 may be a silicon on insulator (SOI) substrate. However, the material of the substrate 110 is not limited to this, and any commonly used substrate may be applied. In some cases, the substrate 110 may include an insulating material. For example, several layer including the channel layer 132 may be first formed on a semiconductor substrate, and then the semiconductor substrate may be removed and replaced with an insulating substrate.

The seed layer 115 may be positioned on the substrate 110. The seed layer 115 may be positioned directly above the substrate 110. However, it is not limited to this, and another predetermined layer may be further positioned between the substrate 110 and the seed layer 115. The seed layer 115 is a layer that serves as a seed for growing the buffer layer 120, and may be made of a crystal lattice structure that becomes the seed of the buffer layer 120. For example, the seed layer 115 may include AlN, but is not limited thereto.

The buffer layer 120 may be positioned above the seed layer 115. The buffer layer 120 may be positioned directly above the seed layer 115. However, it is not limited to this, and another predetermined layer may be further positioned between the seed layer 115 and the buffer layer 120. The buffer layer 120 may be positioned between the seed layer 115 and the channel layer 132. The buffer layer 120 may include one or more materials selected from Group III-V materials, for example, nitrides containing at least one of Al, Ga, In, and B. The buffer layer 120 may be AlxInyGa1-x-yN (0≤x≤1, 0≤y≤1, x+y≤1). For example, the buffer layer 120 may include at least one of AlN, GaN, InN, InGaN, AlGaN, AlInN, and AlInGaN. The buffer layer 120 may be composed of a single layer or multiple layers. The buffer layer 120 may include a superlattice layer 124 and a high-resistance layer 126 positioned on the superlattice layer 124. The high-resistance layer 126 may be positioned above the superlattice layer 124. At least one of the superlattice layer 124 and the high-resistance layer 126 may be omitted. In some implementations, the buffer layer 120 may include not only the superlattice layer 124 and the high-resistance layer 126, but also other additional layers.

The superlattice layer 124 may be positioned above the seed layer 115. The superlattice layer 124 may be positioned directly above the seed layer 115. However, it is not limited to this, and another predetermined layer may be positioned between the seed layer 115 and the superlattice layer 124. The superlattice layer 124 may be positioned between the substrate 110 and the channel layer 132. The superlattice layer 124 may alleviate the difference in lattice constant and thermal expansion coefficient between the substrate 110 and the channel layer 132, thereby alleviating a tensile stress and compressive stress generated between the substrate 110 and the channel layer 132, and/or the superlattice layer 124 may be a layer for relieving stress between all layers formed by growth in the final structure of a semiconductor device according to an embodiment. The superlattice layer 124 may include one or more materials selected from Group III-V materials, for example, nitrides containing at least one of Al, Ga, In, and B. The superlattice layer 124 may be AlxInyGa1-x-yN (0≤x≤1, 0≤y≤1, x+y≤1). For example, the superlattice layer 124 may include at least one of AlN, GaN, InN, InGaN, AlGaN, AlInN, and AlInGaN. The superlattice layer 124 may be composed of a single layer or multiple layers. For example, the superlattice layer 124 may have a structure in which a layer made of AlGaN and a layer made of GaN are repeatedly stacked. For example, AlGaN/GaN/AlGaN/GaN/AlGaN/GaN may be sequentially stacked on the seed layer 115 to form the superlattice layer 124. The number of AlGaN layers and GaN constituting the superlattice layer 124 may vary, and the material constituting the superlattice layer 124 may vary.

The high-resistance layer 126 may be positioned above the superlattice layer 124. The high-resistance layer 126 may be positioned directly above the superlattice layer 124. However, it is not limited to this, and another predetermined layer may be further positioned between the superlattice layer 124 and the high-resistance layer 126. The high-resistance layer 126 may be positioned between the superlattice layer 124 and the channel layer 132. The high-resistance layer 126 is used to reduce or prevent leakage current from flowing through the channel layer 132, thereby reducing or preventing degradation of the semiconductor device according to some implementations. The high-resistance layer 126 may be made of a material with low conductivity so that it may be electrically insulated between the substrate 110 and the channel layer 132. The high-resistance layer 126 may include one or more materials selected from Group III-V materials, for example, nitrides containing at least one of Al, Ga, In, and B. The high-resistance layer 126 may be AlxInyGa1-x-yN (0≤x≤1, 0≤y≤1, x+y≤1). For example, the high-resistance layer 126 may include at least one of AlN, GaN, InN, InGaN, AlGaN, AlInN, and AlInGaN. The high-resistance layer 126 may be composed of a single layer or multiple layers. The high-resistance layer 126 may be a layer whose impurity is not doped. However, it is not limited to this, and the high-resistance layer 126 may include impurity. For example, the high-resistance layer 126 may be doped with impurity made of carbon (C), magnesium (Mg), iron (Fe), or combination thereof. The impurity doping concentration of the high-resistance layer 126 may be different from the impurity doping concentration of the channel layer 132.

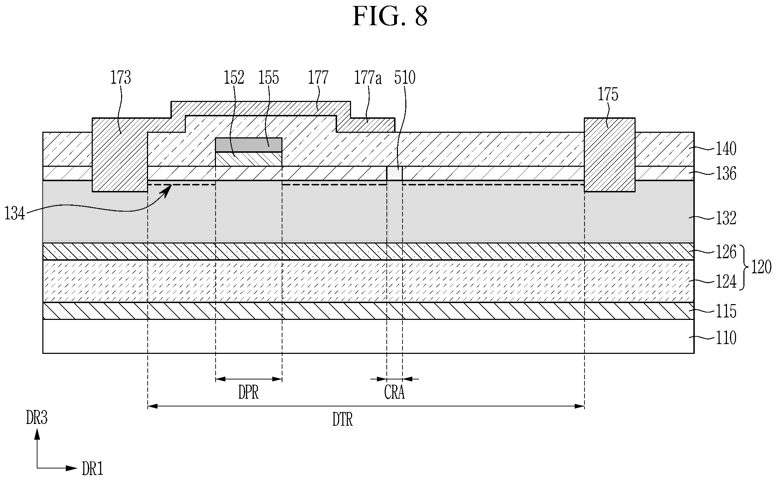

The barrier layer 136 may be positioned above the channel layer 132. The barrier layer 136 may be positioned directly above the channel layer 132. However, it is not limited to this, and another predetermined layer may be further positioned between the channel layer 132 and the barrier layer 136. The region of the channel layer 132 that overlaps the barrier layer 136 may be a drift region DTR. The drift region DTR may be positioned between source electrode 173 and drain electrode 175. When a potential difference occurs between the source electrode 173 and the drain electrode 175, carriers may move in the drift region DTR. Depending on whether a voltage is applied to the gate electrode 155 and the size of the voltage applied to the gate electrode 155, a semiconductor device according to some implementations may be turned on/off. When no voltage is applied to the gate electrode 155, the two-dimensional electron gas 134 may be used as a channel, and current flow may occur between the source electrode 173 and the drain electrode 175. That is, carrier movement may occur in the drift region DTR. Additionally, when a negative voltage is applied to the gate electrode 155, a depletion region DPR in which the flow of the two-dimensional electron gas 134 is interrupted may occur at the bottom of the gate electrode 155. That is, a semiconductor device according to an embodiment may be a normally-on high electron mobility transistor. However, it is not limited to this, and the semiconductor device according to some implementations may be a normally-off high electron mobility transistor. In the case of a normally-off high electron mobility transistor, a gate semiconductor layer may be further positioned between the barrier layer 136 and the gate electrode 155, and this will be described later in the explanation of FIG. 8.

The barrier layer 136 may include a doping region 510. The doping region 510 of the barrier layer 136 may be a region doped with a predetermined ion. The doping region 510 of barrier layer 136 may include Ar, N, etc. For example, the doping region 510 may be formed by implanting Ar, N, etc. into the barrier layer 136 using an ion implantation (IIP) method. A depth of the doping region 510 may correspond to a thickness of the barrier layer 136. That is, the depth of the doping region 510 may be substantially the same as the thickness of the barrier layer 136. However, it is not limited to this, and the depth of the doping region 510 may be smaller or larger than the thickness of the barrier layer 136. In some implementations, the doping region 510 may also be formed within the channel layer 132. The doping region 510 may have a circular shape in plane. However, it is not limited to this, and the planar shape of the doping region 510 may be changed in various ways. For example, the doping region 510 may have a polygonal shape such as a quadrangle or hexagon on a plane.

As the doping region 510 of the barrier layer 136 is doped with Ar, N, etc., the channel may be suppressed in some regions within the channel layer 132. The channel layer 132 may include a channel suppression region CRA, and the doping region 510 of the barrier layer 136 may overlap the channel suppression region CRA of the channel layer 132 in a third direction DR3. The channel suppression region CRA may be positioned within the drift region DTR, and may be a region where the channel is suppressed by the doping region 510. The two-dimensional electron gas 134 may not be formed in the channel suppression region CRA. In other words, the flow of the two-dimensional electron gas 134 may be interrupted in the channel suppression region CRA. In some implementations, an amount of the two-dimensional electron gas 134 in the channel suppression region CRA may be formed to be extremely small compared to other regions. That is, the flow of the two-dimensional electron gas 134 in the channel suppression region CRA may be greatly reduced.

The barrier layer 136 may include a plurality of doping regions 510. The plurality of doping regions 510 may be arranged to be spaced apart from each other at a predetermined interval along a second direction DR2. An interval between the plurality of doping regions 510 may be constant. A shape, size, etc. of the plurality of doping regions 510 may be constant. However, it is not limited to this, and at least some of the plurality of doping regions 510 may have different spacing (or interval), shape, size, etc. To correspond to the plurality of doping regions 510, the channel layer 132 may include a plurality of channel suppression regions CRAs. The plurality of channel suppression regions CRAs may be arranged to be spaced apart from each other at regular intervals along the second direction DR2.

The barrier layer 136 may include one or more materials selected from Group III-V materials, for example, nitrides containing at least one of Al, Ga, In, and B. The barrier layer 136 may be AlxInyGa1-x-yN (0≤x≤1, 0≤y≤1, x+y≤1). The barrier layer 136 may include at least one of GaN, InN, AlGaN, AlInN, InGaN, AlN, AlInGaN, etc. An energy band gap of the barrier layer 136 may be adjusted by the composition ratio of Al and/or In.

The barrier layer 136 may include a semiconductor material with characteristics different from those of the channel layer 132. The barrier layer 136 may differ from the channel layer 132 in at least one of polarization characteristic, energy band gap, and lattice constant. For example, the barrier layer 136 may include a material having a different energy band gap than the channel layer 132. At this time, the barrier layer 136 may have a higher energy band gap than the channel layer 132 and may have a higher electrical polarization rate than the channel layer 132. By this barrier layer 136, the two-dimensional electron gas 134 may be induced in the channel layer 132 which has a relatively low electrical polarization rate. In this regard, the barrier layer 136 may also be called a channel supply layer or a two-dimensional electron gas supply layer. The two-dimensional electron gas 134 may be formed within a portion of the channel layer 132 positioned below an interface between the channel layer 132 and the barrier layer 136. The two-dimensional electron gas 134 may have very high electron mobility.

The barrier layer 136 may be composed of a single layer or multiple layers. When the barrier layer 136 is made of multiple layers, the materials of respective layers constituting the multilayer may have different energy band gaps. Accordingly, the multiple layers constituting the barrier layer 136 may be arranged so that the energy band gap increases as the multiple layers approach the channel layer 132.

The gate electrode 155 may be positioned on barrier layer 136. The gate electrode 155 may be positioned directly above barrier layer 136. A bottom surface of the gate electrode 155 may be in contact with the barrier layer 136. However, it is not limited to this, and another predetermined layer may be further positioned between the gate electrode 155 and the barrier layer 136. The gate electrode 155 may overlap some regions of barrier layer 136. The gate electrode 155 may overlap a portion of the drift region DTR in the channel layer 132. The gate electrode 155 may be positioned between the source electrode 173 and the drain electrode 175. The gate electrode 155 may be separated from source electrode 173 and drain electrode 175 in a first direction DR1. The first direction DR1 may be a direction parallel to an upper surface of the substrate 110 or an upper surface of the channel layer 132. The gate electrode 155 may be positioned closer to the source electrode 173 than the drain electrode 175. For example, a separation distance between the gate electrode 155 and the source electrode 173 may be smaller than a separation distance between the gate electrode 155 and the drain electrode 175.

The gate electrode 155 may extend in a second direction DR2, which is different from the first direction DR1 on the plane. The second direction DR2 may be a direction parallel to the upper surface of the substrate 110 or the upper surface of the channel layer 132, and may be a direction that intersects the first direction DR1. For example, the second direction DR2 may be a direction orthogonal to the first direction DR1. The gate electrode 155 may have a bar shape extending along the second direction DR2.

The gate electrode 155 may contain conductive material. For example, the gate electrode 155 may include metal, metal alloy, conductive metal nitride, metal silicide, doped semiconductor material, conductive metal oxide, or conductive metal nitride. For example, the gate electrode 155 is titanium nitride (TiN), tantalum carbide (TaC), tantalum nitride (TaN), titanium silicon nitride (TiSiN), tantalum silicon nitride (TaSiN), tantalum titanium nitride (TaTiN), titanium aluminum nitride. (TiAlN), tantalum aluminum nitride(TaAlN), tungsten nitride(WN), ruthenium(Ru), titanium aluminum(TiAl), titanium aluminum carbonizationnitride(TiAlC-N), titanium aluminum carbide(TiAlC), titanium carbide(TiC), tantalum carbonizationnitride(TaCN), tungsten(W), aluminum(Al), copper(Cu), cobalt(Co), titanium(Ti), tantalum(Ta), nickel(Ni), platinum(Pt), nickel platinum(Ni)-Pt), niobium(Nb), niobium nitride(NbN), niobium carbide(NbC), molybdenum(Mo), molybdenum nitride(MoN), molybdenum carbide(MoC), tungsten carbide(WC), rhodium(Rh), palladium It may include (Pd), iridium (Ir), osmium (Os), silver (Ag), gold (Au), zinc (Zn), vanadium (V), or combinations thereof, but is not limited thereto. The gate electrode 155 may be made of a single layer or multiple layers.

The buffer layer 120, the superlattice layer 124, the high-resistance layer 126, the channel layer 132, and the barrier layer 136 described above may be sequentially stacked on the substrate 110. In some implementations, at least one of the buffer layer 120, the superlattice layer 124, the high-resistance layer 126, the channel layer 132, and the barrier layer 136 may be omitted. These buffer layer 120, the superlattice layer 124, the high-resistance layer 126, the channel layer 132, and the barrier layer 136 may be made of the same-based semiconductor material, and material composition ratios of respective layers may be different considering roles of respective layers and/or the performance required for the semiconductor device, etc.

In some implementations, a protective layer 140 may be positioned on the barrier layer 136 and the gate electrode 155. The protective layer 140 may cover the upper surface of the barrier layer 136, and may cover the upper surface and side surfaces of the gate electrode 155. The protective layer 140 may be in contact with the barrier layer 136 and the gate electrode 155. The barrier layer 136 and the gate electrode 155 may be protected by the protective layer 140, and may be separated from other components. The protective layer 140 may include an insulating material. For example, the protective layer 140 may include oxide such as SiO2 or Al2O3. As another example, the protective layer 140 may include a nitride, such as SiN, or an acid nitride, such as SiON. The protective layer 140 may be composed of a single layer or multiple layers.

The source electrode 173 and drain electrode 175 may be positioned on the channel layer 132. The source electrode 173 and the drain electrode 175 may be spaced apart from each other, and the gate electrode 155 may be positioned between the source electrode 173 and the drain electrode 175. The gate electrode 155 is spaced apart from the source electrode 173 and the drain electrode 175. The source electrode 173 may be electrically connected to the channel layer 132 on one side of the gate electrode 155. The drain electrode 175 may be electrically connected to the channel layer 132 on the other side of the gate electrode 155. The source electrode 173 and drain electrode 175 may be positioned outside the drift region DTR of the channel layer 132. An interface surface between the source electrode 173 and the channel layer 132 may be one edge of the drift region DTR. Likewise, the interface surface between the drain electrode 175 and the channel layer 132 may be the other edge of the drift region DTR. However, the present disclosure is not limited to this, and the source electrode 173 and the drain electrode 175 may not be positioned outside the drift region DTR of the channel layer 132. In some implementations, the channel layer 132 may not be recessed, and the source electrode 173 and the drain electrode 175 may be positioned on the upper surface of the channel layer 132. In some implementations, the barrier layer 136 may not be penetrated, and a portion of the barrier layer 136 may be recessed, so that the source electrode 173 and the drain electrode 175 may be positioned on the upper surface of the barrier layer 136. Bottom surfaces of the source electrode 173 and the drain electrode 175 may be in contact with the upper surface of the barrier layer 136. Portions of the barrier layer 136 in contact with the source electrode 173 and the drain electrode 175 may be doped with high concentration. In some implementations, a carrier passing through the two-dimensional electron gas 134 may pass through the portion of the barrier layer 136 doped at high concentration, that is, the top portion of the two-dimensional electron gas 134, and may be transferred to the source electrode 173 and the drain electrode 175. The source electrode 173 and drain electrode 175 may not directly contact the two-dimensional electron gas 134 in the horizontal direction. The horizontal direction may mean a direction parallel to the upper surface of the channel layer 132 or the barrier layer 136.

The source electrode 173 and the drain electrode 175 may be positioned on the protective layer 140. Trenches that penetrate the protective layer 140 and the barrier layer 136 and recess upper surfaces of the channel layer 132 may be positioned on both sides of the gate electrode 155 to be spaced apart from each other. The source electrode 173 and the drain electrode 175 may be positioned in trenches positioned on both sides of the gate electrode 155, respectively. The source electrode 173 and the drain electrode 175 may be formed to fill within the trenches. Within the trenches, the source electrode 173 and drain electrode 175 may be in contact with the channel layer 132 and the barrier layer 136. The channel layer 132 may form a bottom surface and sidewalls of a trench, and the barrier layer 136 may form the sidewalls of the trench. Accordingly, the source electrode 173 and the drain electrode 175 may contact the top surfaces and the side surfaces of the channel layer 132. Additionally, the source electrode 173 and the drain electrode 175 may be in contact with the sides of the barrier layer 136. In some implementations, the source electrode 173 and the drain electrode 175 may cover the sides of the channel layer 132 and the barrier layer 136. The upper surfaces of the source electrode 173 and the drain electrode 175 may be protruded from the upper surface of the protective layer 140. In some implementations, at least one of the source electrode 173 and the drain electrode 175 may cover at least a portion of the upper surface of the protective layer 140.

The source electrode 173 and the drain electrode 175 may be separated in the first direction DR1. The source electrode 173 and the drain electrode 175 may be extended in the second direction DR2. The source electrode 173 and the drain electrode 175 may extend in a direction parallel to the gate electrode 155.

The source electrode 173 and the drain electrode 175 may include conductive material. For example, the source electrode 173 and the drain electrode 175 may include metal, metal alloy, conductive metal nitride, metal silicide, doped semiconductor material, conductive metal oxide, or conductive metal nitride. For example, the source electrode 173 and the drain electrode 175 may include titanium nitride (TiN), tantalum carbide (TaC), tantalum nitride (TaN), titanium silicon nitride (TiSiN), tantalum silicon nitride (TaSiN), tantalum titanium nitride (TaTiN). , titanium aluminum nitride(TiAlN), tantalum aluminum nitride(TaAlN), tungsten nitride(WN), ruthenium(Ru), titanium aluminum(TiAl), titanium aluminum carbonizationnitride(TiAlC-N), titanium aluminum carbide(TiAlC), titanium carbide (TiC), tantalum carbonizationnitride(TaCN), tungsten(W), aluminum(Al), copper(Cu), cobalt(Co), titanium(Ti), tantalum(Ta), nickel(Ni), platinum(Pt), nickel platinum(Ni-Pt), niobium(Nb), niobium nitride(NbN), niobium carbide(NbC), molybdenum(Mo), molybdenum nitride(MoN), molybdenum carbide(MoC), tungsten carbide(WC), rhodium( Rh), palladium (Pd), iridium (Ir), osmium (Os), silver (Ag), gold (Au), zinc (Zn), vanadium (V), or combinations thereof, but are not limited thereto. The source electrode 173 and the drain electrode 175 may be made of a single layer or multiple layers. The source electrode 173 and drain electrode 175 may be in ohmic contacts with the channel layer 132. Regions in contact with the source electrode 173 and the drain electrode 175 within the channel layer 132 may be doped at a relatively high concentration compared to other regions.

The field dispersion layer 177 may be positioned between the source electrode 173 and the drain electrode 175. The field dispersion layer 177 may overlap the gate electrode 155 in the third direction DR3. The third direction DR3 may be a vertical direction to the first direction DR1 and the second direction DR2. For example, the third direction DR3 may be a vertical direction to the upper surface of the substrate 110 or the upper surface of the channel layer 132. The gate electrode 155 may be covered by the field dispersion layer 177. The field dispersion layer 177 may be electrically connected to the source electrode 173. The field dispersion layer 177 may include the same material as the source electrode 173 and may be positioned in the same layer as the source electrode 173. The field dispersion layer 177 may be formed simultaneously in the same process as the source electrode 173. The interface between the field dispersion layer 177 and the source electrode 173 is not clear, and the field dispersion layer 177 may be formed integrally with the source electrode 173. However, it is not limited to this, and the field dispersion layer 177 may be a separate component from the source electrode 173. Additionally, the field dispersion layer 177 may be positioned in a different layer from the source electrode 173 and may be formed in a different process. In some implementations, the field dispersion layer 177 may be electrically connected to the gate electrode 155. For example, an opening that overlaps the gate electrode 155 may be formed in the protective layer 140, and the field dispersion layer 177 may be connected to the gate electrode 155 through the opening. In some implementations, the field dispersion layer 177 may not be connected to the source electrode 173. As another example, from a plan view, the field dispersion layer 177 may be positioned between the gate electrode 155 and the drain electrode 175, and may be floating rather than connecting to a gate electrode 155 and the drain electrode 175.

The field dispersion layer 177 may serve to disperse an electric field concentrated around the gate electrode 155. When a high voltage is applied to the drain electrode 175 in the gate off state, an electric field may be concentrated around the gate electrode 155. When the electric field is concentrated on the gate electrode 155, a leakage current may increase and a breakdown voltage may decrease. The electric field concentrated around the gate electrode 155 may be dispersed by the field dispersion layer 177, thereby reducing the leakage current and/or increasing the breakdown voltage.

The field dispersion layer 177 may include a protruding portion 177a. The protruding portion 177a of the field dispersion layer 177 may be protruded toward the drain electrode 175 from an edge of the field dispersion layer 177 adjacent to the drain electrode 175. The protruding portion 177a may be protruded in the first direction DR1 from the edge of the field dispersion layer 177 on a plane.

The protruding portion 177a may be adjacent to a channel suppression region CRA of the channel layer 132. The protruding portion 177a may overlap the channel suppression region CRA of the channel layer 132 in the third direction DR3. At least a portion of the protruding portion 177a may overlap the channel suppression region CRA of the channel layer 132 in the third direction DR3. A portion of the protruding portion 177a may overlap the channel suppression region CRA, and another portion of the protruding portion 177a may not overlap the channel suppression region CRA. However, it is not limited to this, and the entire protruding portion 177a may overlap the channel suppression region CRA. The protruding portion 177a may overlap at least a portion of the channel suppression region CRA in the third direction DR3. The protruding portion 177a may overlap a portion of the channel suppression region CRA and may not overlap another portion of the channel suppression region CRA. However, it is not limited to this, and the protruding portion 177a may overlap the entire channel suppression region CRA.

The protruding portion 177a may be adjacent to the doping region 510 of the barrier layer 136. The protruding portion 177a may overlap the doping region 510 of the barrier layer 136 in the third direction DR3. At least a portion of the protruding portion 177a may overlap the doping region 510 of the barrier layer 136 in the third direction DR3. The protruding portion 177a may overlap at least a portion of the doping region 510 of the barrier layer 136 in the third direction DR3.

The protruding portion 177a may have an approximately square shape in plan view. However, it is not limited to this, and the planar shape of the protruding portion 177a maybe changed in various ways. The protruding portion 177a may have a predetermined length Lth along the first direction DR1 and a predetermined width Wth along the second direction DR2. A length Lth of the protruding portion 177a along the first direction DR1 may be about 0.1 µm or more and/or about 2 µm or less. A width Wth of the protruding portion 177a along the second direction DR2 may be about 0.05 µm or more and/or about 5 µm or less.

The field dispersion layer 177 may include a plurality of protruding portions 177a. The plurality of protruding portions 177a may be arranged to be spaced apart at a predetermined interval along the second direction DR2. An interval between the plurality of protruding portions 177a may be constant. A shape, size, etc. of the plurality of protruding portions 177a may be constant. However, it is not limited to this, and at least a portion of the plurality of protruding portions 177a may have different interval, shape, size, etc. The plurality of protruding portions 177a may correspond to the plurality of channel suppression regions CRA, respectively. Each of the plurality of protruding portions 177a may overlap the channel suppression region CRA. The number of the plurality of protruding portions 177a may correspond to the number of the plurality of channel suppression regions CRA. The number of the plurality of protruding portions 177a may be substantially the same as the number of the plurality of channel suppression regions CRA. The plurality of protruding portions 177a may correspond to the plurality of doping regions 510, respectively. Each of the plurality of protruding portions 177a may overlap the doping region 510. The number of plurality of protruding portions 177a may correspond to the number of plurality of doping regions 510. The number of plurality of protruding portions 177a may be substantially the same as the number of plurality of doping regions 510.

In some implementations, a channel suppression region CRA may be formed in the channel layer 132 by the doping region 510 formed in the barrier layer 136. This channel suppression region CRA may be positioned adjacent to the edge of the field dispersion layer 177 adjacent to the drain electrode 175. Accordingly, the electric field concentrated at the edge of the field dispersion layer 177 adjacent to the drain electrode 175 may be dispersed. Additionally, in some implementations, a protruding portion 177a may be formed at the edge of the field dispersion layer 177 adjacent to the drain electrode 175 to overlap the channel suppression region CRA. Accordingly, the electric field concentrated at the edge of the field dispersion layer 177 adjacent to the drain electrode 175 may be further dispersed, and the semiconductor device according to an embodiment may be prevented from being degraded or degradation is reduced.

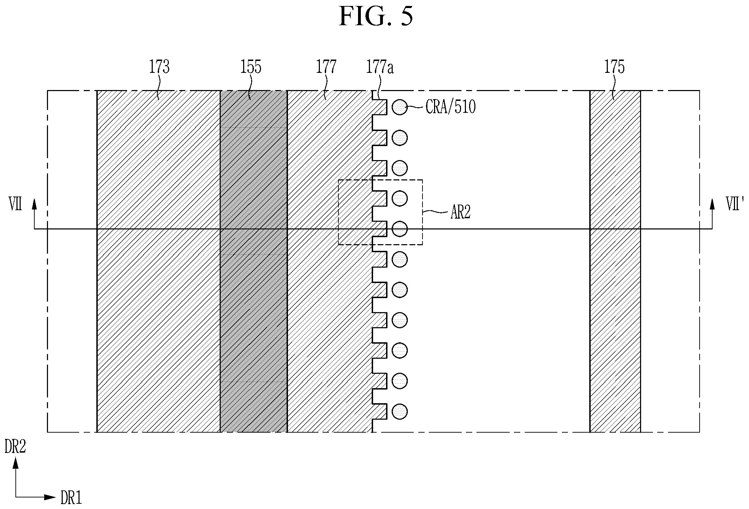

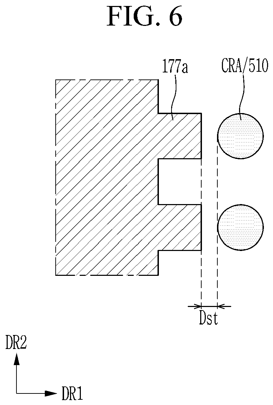

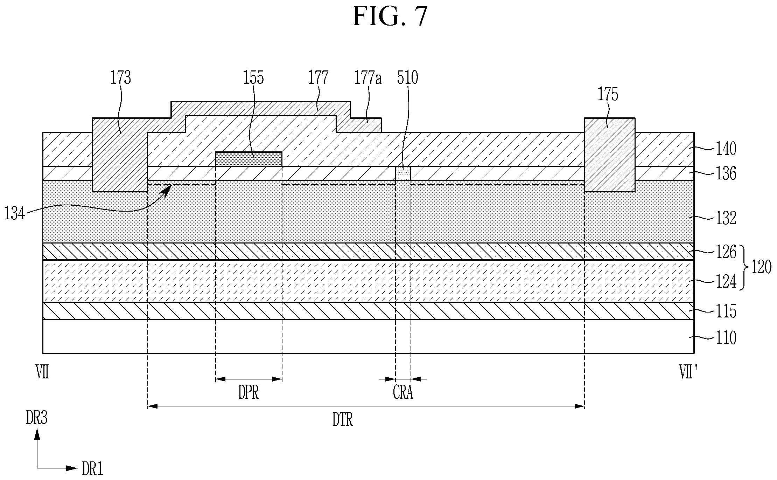

FIG. 5 is a plan view showing an example of a semiconductor device according to some implementations. FIG. 6 is an enlarged plan view of an example of an AR2 region in FIG. 5 according to some implementations. FIG. 7 is a cross-sectional view shown along line VII-VII' in Fig. 5 according to some implementations.

Since implementations shown in FIGS. 5 to 7 are substantially the same as embodiments shown in FIGS. 1 to 4, description thereof will be omitted and the differences will be mainly explained. In addition, the same reference numerals are used for the same components as the previous embodiment. Some implementations shown in FIG. 5 to FIG. 7 may be slightly different from other implementations in that a channel suppress portion does not overlap the field dispersion layer.

In FIGS. 5 to 7, the doping region 510 of the barrier layer 136 is positioned adjacent to the field dispersion layer 177 and may not overlap the field dispersion layer 177 in the third direction DR3. The doping region 510 of the barrier layer 136 may not overlap the protruding portion 177a of the field dispersion layer 177 in the third direction DR3. The doping region 510 of the barrier layer 136 may be separated from the protruding portion 177a of the field dispersion layer 177 in the first direction DR1. A separation distance between the doping region 510 and the protruding portion 177a along the first direction DR1 may be about 0.5 µm or less.

The channel suppression region CRA of the channel layer 132 may correspond to the doping region 510 of the barrier layer 136. The channel suppression region CRA of the channel layer 132 may overlap the doping region 510 of the barrier layer 136 in the third direction DR3. The channel suppression region CRA of the channel layer 132 is positioned adjacent to the field dispersion layer 177, and may not overlap the field dispersion layer 177 in the third direction DR3. The channel suppression region CRA of the channel layer 132 may not overlap the protruding portion 177a of the field dispersion layer 177 in the third direction DR3. The channel suppression region CRA of the channel layer 132 may be separated from the protruding portion 177a of the field dispersion layer 177 in the first direction DR1. A separation distance Dst between the channel suppression region CRA and the protruding portion 177a along the first direction DR1 may be about 0.5 µm or less.

The plurality of protruding portions 177a may be arranged to be spaced apart at a predetermined interval along the second direction DR2. The plurality of protruding portions 177a may correspond to the plurality of channel suppression regions CRA, respectively. Each of the plurality of protruding portions 177a may be spaced apart from the channel suppression region CRA in first direction DR1. The plurality of protruding portions 177a may correspond to the plurality of doping regions 510, respectively. Each of the plurality of protruding portions 177a may be spaced apart from the doping region 510 in the first direction DR1.

FIG. 8 is a cross-sectional view showing an example of a semiconductor device according to some implementations. Since implementations shown in FIG. 8 is substantially the same as implementations shown in FIGS. 1 to 4, description thereof will be omitted and the differences will be mainly explained. In addition, the same reference numerals are used for the same components as the previous embodiment. An implementation shown in FIG. 8 may be slightly different from previous implementations in that it further includes a gate semiconductor layer.

In FIG. 8, a semiconductor device may include a channel layer 132, a barrier layer 136 positioned above the channel layer 132, a gate electrode 155 positioned above the barrier layer 136, a protective layer 140 positioned above the gate electrode 155, a source electrode 173 and a drain electrode 175 that are positioned on both sides of the gate electrode 155 and connected to the channel layer 132, and a field dispersion layer 177 positioned on the protective layer 140. A semiconductor device may further include a gate semiconductor layer 152 positioned between the barrier layer 136 and the gate electrode 155.

The gate semiconductor layer 152 may be positioned on the barrier layer 136, and the gate electrode 155 may be positioned on the gate semiconductor layer 152. The gate electrode 155 may be a Schottky contact to the gate semiconductor layer 152. However, it is not limited to this, and in some implementations, the gate electrode 155 may be in ohmic contact with the gate semiconductor layer 152. The gate semiconductor layer 152 may overlap gate electrode 155 in the third direction DR3.

The buffer layer 120, the superlattice layer 124, the high-resistance layer 126, the channel layer 132, the barrier layer 136, and the gate semiconductor layer 152 may be sequentially stacked on the substrate 110. In some implementations, at least one of the buffer layer 120, the superlattice layer 124, the high-resistance layer 126, the channel layer 132, the barrier layer 136, and the gate semiconductor layer 152 may be omitted. The buffer layer 120, superlattice layer 124, high-resistance layer 126, channel layer 132, barrier layer 136, and gate semiconductor layer 152 may be made of the same or same-based semiconductor material, and material composition ratios of respective layers may be different considering roles of respective layers and/or the performance required for the semiconductor device, etc.

The gate semiconductor layer 152 may be positioned between the source electrode 173 and the drain electrode 175. The gate semiconductor layer 152 may be separated from the source electrode 173 and the drain electrode 175. The gate semiconductor layer 152 may be positioned closer to the source electrode 173 than the drain electrode 175. For example, a separation distance between the gate semiconductor layer 152 and the source electrode 173 may be smaller than a separation distance between the gate semiconductor layer 152 and the drain electrode 175.

The gate semiconductor layer 152 may include one or more materials selected from group III-V materials, for example, nitrides containing at least one of Al, Ga, In, and B. The gate semiconductor layer 152 may be AlxInyGa1-x-yN (0≤x≤1, 0≤y≤1, x+y≤1). For example, the gate semiconductor layer 152 may include at least one of AlN, GaN, InN, InGaN, AlGaN, AlInN, and AlInGaN. The gate semiconductor layer 152 may include a material having a different energy band gap than the barrier layer 136. For example, the gate semiconductor layer 152 may include GaN, and the barrier layer 136 may include AlGaN. The gate semiconductor layer 152 may be doped to a predetermined impurity. In some implementations, the impurity doped in the gate semiconductor layer 152 may be a P-type dopant that may provide a hole. For example, the gate semiconductor layer 152 may include GaN with doped P-type impurity. For example, the gate semiconductor layer 152 may be made of a p-GaN layer. However, it is not limited to this, and the gate semiconductor layer 152 may be a p-AlGaN layer. For example, the impurity doped in the gate semiconductor layer 152 may be Mg, F, Be, Ca, Sr, Ba, Li, Na, Mn, Fe, Co, Cu, Zn, Cd, etc. The gate semiconductor layer 152 may be composed of a single layer or multiple layers.

A depletion region DPR may be formed within the channel layer 132 by the gate semiconductor layer 152. The depletion region DPR may be positioned within the drift region DTR and may have a narrower width than the drift region DTR. As the gate semiconductor layer 152 having a different energy band gap from the barrier layer 136 is positioned on the barrier layer 136, the level of the energy band of the portion of the barrier layer 136 that overlaps the gate semiconductor layer 152 may increase. Accordingly, the depletion region DPR may be formed in the region of the channel layer 132 that overlaps the gate semiconductor layer 152. The depletion region DPR may be a region in the channel path of the channel layer 132 in which the two-dimensional electron gas 134 is not formed or has a lower electron concentration than the remaining regions. In other words, the depletion region DPR may mean a region where the flow of the two-dimensional electron gas 134 is interrupted within the drift region DTR. As the depletion region DPR occurs, current does not flow between the source electrode 173 and the drain electrode 175, and the channel path may be blocked. When a voltage higher than a threshold voltage is applied to the gate electrode 155 and the semiconductor device is turned on, a channel may be created in the depletion region DPR. Accordingly, movement of the carrier may occur in the drift region DTR. When a voltage lower than the threshold voltage is applied to the gate electrode 155 or no voltage is applied, the channel path may be blocked in the depletion region DPR and carrier movement may not occur.

In some implementations, the semiconductor device may be a normally off high electron mobility transistor (HEMT). In a normal state in which no voltage is applied to the gate electrode 155, a depletion region DPR exists, and the semiconductor device may be in an off state. When a voltage higher than the threshold voltage is applied to the gate electrode 155, the depletion region DPR disappears, and the two-dimensional electron gas 134 is not disconnected and may be connected within the drift region DTR. For example, the two-dimensional electron gas 134 may be formed throughout the channel path between the source electrode 173 and the drain electrode 175, and the semiconductor device may be turned on. In some implementations, a semiconductor device may include semiconductor layers with different electrical polarization characteristics, and a semiconductor layer with a relatively large polarization rate may cause the two-dimensional electron gas 134 to another semiconductor layer heterogeneously junctioned with the semiconductor layer. This two-dimensional electron gas 134 may be used as a channel between the source electrode 173 and the drain electrode 175, and the continuation or interruption of the flow of this two-dimensional electron gas 134 may be controlled by the bias voltage applied to the gate electrode 155.. In the gate off state, the flow of the two-dimensional electron gas 134 is blocked, so current may not flow between the source electrode 173 and the drain electrode 175. As the flow of two-dimensional electron gas 134 continues in the gate on state, current may flow between the source electrode 173 and the drain electrode 175.

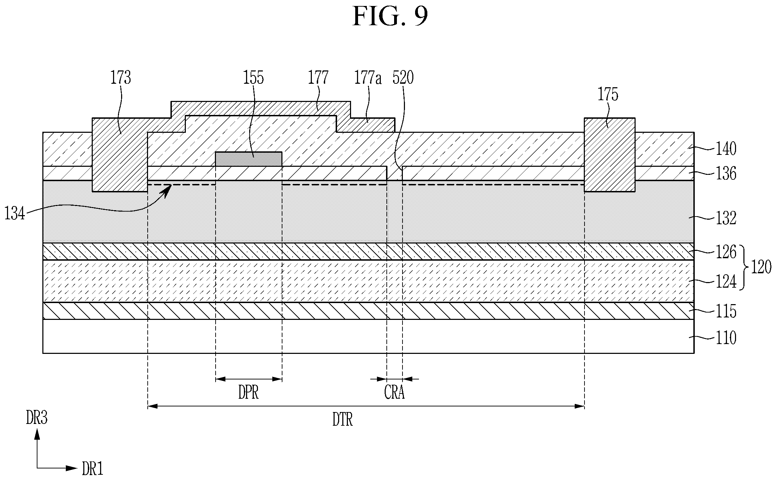

FIG. 9 is a cross-sectional view showing an example of a semiconductor device according to some implementations. Since elements shown in FIG. 9 is substantially the same as the elements shown in FIGS. 1 to 4, description thereof will be omitted and the differences will be mainly explained. In addition, the same reference numerals are used for the same components as previous implementations. In FIG. 9, the doping region 510 is not formed in the barrier layer 136, and instead, a recess 520 is formed in the barrier layer 136, which may be slightly different from the previous embodiment.

In FIG. 9, the barrier layer 136 may be positioned above the channel layer 132. The recess 520 may be formed in which at least a portion of the barrier layer 136 is removed. The depth of the recess 520 may correspond to the thickness of the barrier layer 136. The depth of the recess 520 may be substantially the same as the thickness of the barrier layer 136. However, it is not limited to this, and the depth of the recess 520 may be smaller or larger than the thickness of the barrier layer 136. In some implementations, the recess 520 may also be formed in the channel layer 132. The protective layer 140 may be positioned within the recess 520. For example, the recess 520 may be filled with the protective layer 140.

In some implementations, a portion where the recess 520 is formed in the barrier layer 136 may correspond to a portion where the doping region 510 is formed in the barrier layer 136 in previous implementations. In some implementations, the recess 520 of the barrier layer 136 may be similar in position and role to the doping region 510 of the barrier layer 136 in previous implementations. For example, as the recess 520 is formed in the barrier layer 136, the channel may be suppressed in some regions within the channel layer 132. The recess 520 of the barrier layer 136 may overlap the channel suppression region CRA of the channel layer 132 in the third direction DR3.

The protruding portion 177a of the field dispersion layer 177 may be adjacent to the recess 520 of the barrier layer 136. The protruding portion 177a may overlap the recess 520 of the barrier layer 136 in the third direction DR3. At least a portion of the protruding portion 177a may overlap the recess 520 of the barrier layer 136 in the third direction DR3. The protruding portion 177a may overlap at least one portion of the recess 520 of the barrier layer 136 in the third direction DR3.

A plurality of recesses 520 may be formed in the barrier layer 136, and the plurality of recesses 520 may be arranged to be spaced apart along the second direction DR2. The interval between the plurality of recesses 520, the shape and size of the plurality of recesses 520, etc. may be constant, or at least some of them may be different. The plurality of recesses 520 may correspond to the plurality of protruding portions 177a, respectively. The plurality of recesses 520 may correspond to the plurality of channel suppression regions CRAs, respectively.

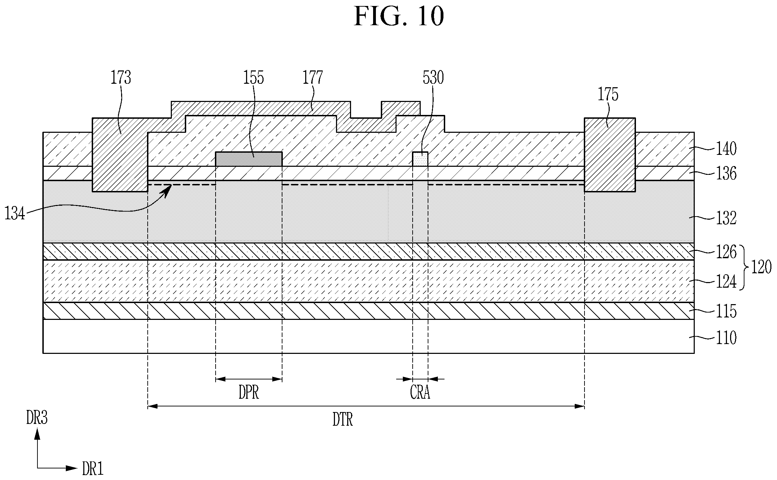

FIG. 10 is a cross-sectional view showing an example of a semiconductor device according to some implementations. Since elements shown in FIG. 10 is substantially the same as the embodiment shown in FIGS. 1 to 4, description thereof will be omitted and the differences will be mainly explained. In addition, the same reference numerals are used for the same components as previous implementations. In FIG. 10, a doping region is not formed in the barrier layer, and instead, a channel suppression pattern is positioned on the barrier layer, which may be slightly different from the previous embodiment.

In FIG. 10, a semiconductor device may include a channel suppression pattern 530 positioned above the barrier layer 136. The barrier layer 136 may be positioned between the channel layer 132 and the channel suppression pattern 530. The channel suppression pattern 530 may include one or more materials selected from Group III-V materials, for example, nitrides containing at least one of Al, Ga, In, and B. The channel suppression pattern 530 may be AlxInyGa1-x-yN (0≤x≤1, 0≤y≤1, x+y≤1). For example, the channel suppression pattern 530 may include at least one of AlN, GaN, InN, InGaN, AlGaN, AlInN, and AlInGaN. The channel suppression pattern 530 may include a material having a different energy band gap than the barrier layer 136. For example, the channel suppression pattern 530 may include GaN, and the barrier layer 136 may include AlGaN. The channel suppression pattern 530 may be doped with a predetermined impurity. At this time, the impurity doped in the channel suppression pattern 530 may be a P-type dopant that may provide a hole. For example, the channel suppression pattern 530 may include GaN with doped P-type impurity. For example, the channel suppression pattern 530 may be made of a p-GaN layer. However, it is not limited to this, and the channel suppression pattern 530 may be a p-AlGaN layer. For example, the impurity doped in the channel suppression pattern 530 may be Mg, F, Be, Ca, Sr, Ba, Li, Na, Mn, Fe, Co, Cu, Zn, Cd, etc. The channel suppression pattern 530 may be made of a single layer or multiple layers.

In some implementations, the portion where the channel suppression pattern 530 is formed on the barrier layer 136 may correspond to the portion where the doping region 510 is formed on the barrier layer 136 in previous implementations. In some implementations, the channel suppression pattern 530 may be similar in position and role to the doping region 510 of the barrier layer 136 in the previous embodiment. For example, as the channel suppression pattern 530 is formed on the barrier layer 136, the channel may be suppressed in some regions within the channel layer 132. The channel suppression pattern 530 may overlap the channel suppression region CRA of the channel layer 132 in the third direction DR3.

The protruding portion 177a of the field dispersion layer 177 may be adjacent to the channel suppression pattern 530. The protruding portion 177a may overlap the channel suppression pattern 530 in third direction DR3. At least a portion of the protruding portion 177a may overlap the channel suppression pattern 530 in third direction DR3. The protruding portion 177a may overlap at least a portion of channel suppression pattern 530 in the third direction DR3.

The plurality of channel suppression patterns 530 may be positioned on the barrier layer 136, and the plurality of channel suppression patterns 530 may be arranged to be spaced apart along the second direction DR2. An interval between the plurality of the channel suppression patterns 530, a shape, size, etc. of the plurality of the channel suppression patterns 530 may be constant, or at least some of them may be different. The plurality of channel suppression patterns 530 may correspond to the plurality of protruding portions 177a, respectively. The plurality of channel suppression patterns 530 may correspond to the plurality of channel suppression regions CRAs, respectively.

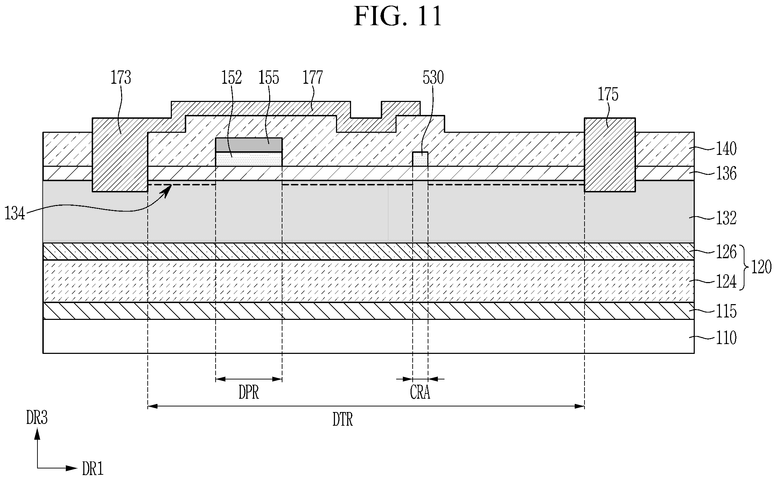

FIG. 11 is a cross-sectional view showing an example of a semiconductor device according to some implementations. Since elements shown in FIG. 11 may be substantially the same as elements shown in FIG. 10, description thereof will be omitted and the differences will be mainly explained. In addition, the same reference numerals are used for the same components as previous implementations. FIG. 11 may be slightly different from previous implementations in that it further includes a gate semiconductor layer.

The semiconductor device shown in FIG. 11 may further include a gate semiconductor layer 152 positioned between the barrier layer 136 and the gate electrode 155. The gate semiconductor layer 152 may be similar to the gate semiconductor layer 152 shown in FIG. 8, and detailed description of the gate semiconductor layer 152 is omitted.

The gate semiconductor layer 152 and the channel suppression pattern 530 may be positioned above the barrier layer 136. The gate semiconductor layer 152 and channel suppression pattern 530 may be positioned on the same layer. The gate semiconductor layer 152 and the channel suppression pattern 530 may be formed in the same process using the same material. Accordingly, the gate semiconductor layer 152 and the channel suppression pattern 530 may include the same material and have substantially the same thickness. By forming the channel suppression pattern 530 together in the gate semiconductor layer 152 forming process, the process may be simplified and costs may be reduced.

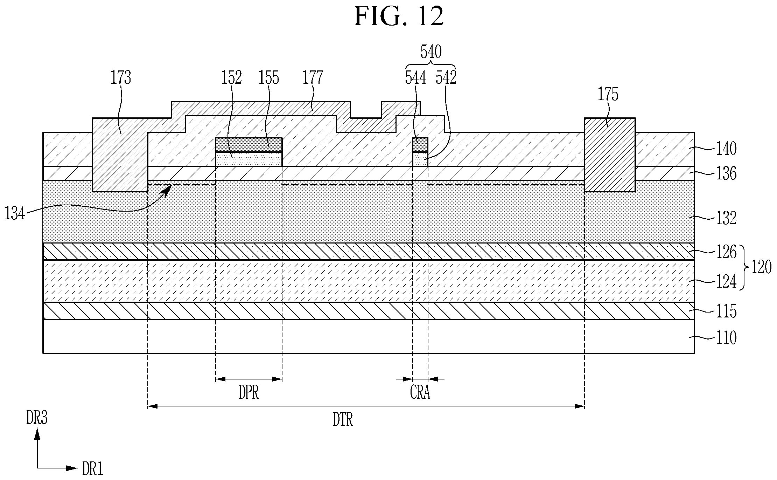

FIG. 12 is a cross-sectional view showing an example of a semiconductor device according to some implementations. Since elements shown in FIG. 12 may be substantially the same as elements shown in FIG. 11, description thereof will be omitted and the differences will be mainly explained. In addition, the same reference numerals are used for the same components as previous implementations. FIG. 12 may be slightly different from previous implementations in that the channel suppression pattern includes a plurality of layers.

In FIG. 12, the channel suppression pattern 540 may be positioned on the barrier layer 136 in a semiconductor device according to an embodiment. The channel suppression pattern 540 may be composed of multiple layers. The channel suppression pattern 540 may include a first layer 542 and a second layer 544 positioned above the first layer 542. The first layer 542 of the channel suppression pattern 540 may be positioned between the barrier layer 136 and the second layer 544. The first layer 542 of the channel suppression pattern 540 may be positioned on the same layer as the gate semiconductor layer 152. The first layer 542 of the channel suppression pattern 540 may be formed in the same process using the same material as the gate semiconductor layer 152. Accordingly, the first layer 542 of the channel suppression pattern 540 and the gate semiconductor layer 152 may include the same material and have substantially the same thickness. The second layer 544 of the channel suppression pattern 540 may be positioned on the same layer as the gate electrode 155. The second layer 544 of the channel suppression pattern 540 may be formed using the same material as the gate electrode 155 in the same process. Accordingly, the second layer 544 and the gate electrode 155 of the channel suppression pattern 540 may include the same material and have substantially the same thickness.

The second layer 544 of the channel suppression pattern 540 may be floating. However, it is not limited to this, and in some implementations, it may be connected to another wire so that a predetermined voltage is applied to the second layer 544 of the channel suppression pattern 540.

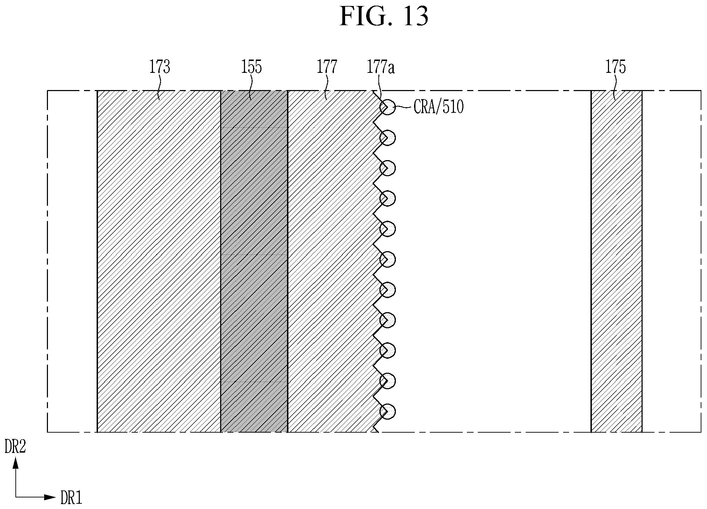

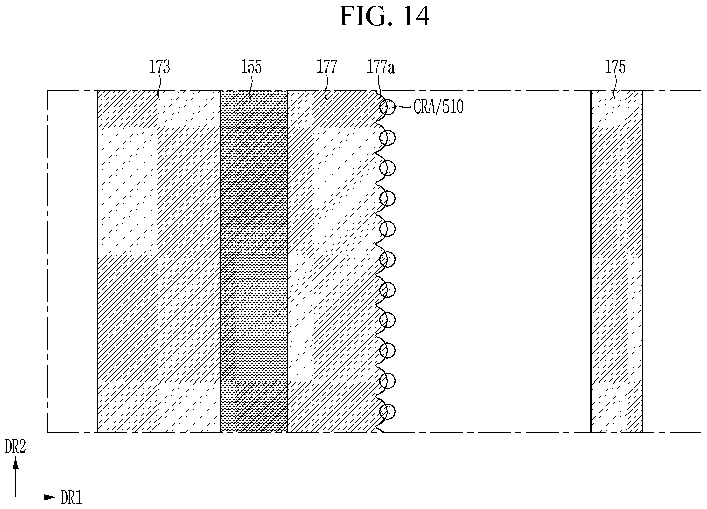

FIG. 13 and FIG. 14 are a plan view showing an example of a semiconductor device according to some implementations. Since elements shown in FIGS. 13 and 14 may be substantially the same as elements shown in FIGS. 1 to 4, description thereof will be omitted and the differences will be mainly explained. In addition, the same reference numerals are used for the same components as previous implementations. In FIG. 13 and FIG. 14, the planar shape of the protruding portion of the field dispersion layer may be slightly different from previous implementations.

In FIG. 13, the protruding portion 177a of the field dispersion layer 177 may have a triangular shape on a plane. The protruding portion 177a may be formed as an isosceles triangle on a plane. As shown in FIG. 14, the protruding portion 177a of the field dispersion layer 177 may have a round shape on a plane. Each of the plurality of protrusions 177a may have a substantially semicircular shape. The plurality of protruding portion 177a may have a shape in which the edges of a semicircular shape are connected to each other.

The planar shapes of the protruding portion 177a of the field dispersion layer 177 are only examples, and the planar shape of the protruding portion 177a may be changed in various ways.

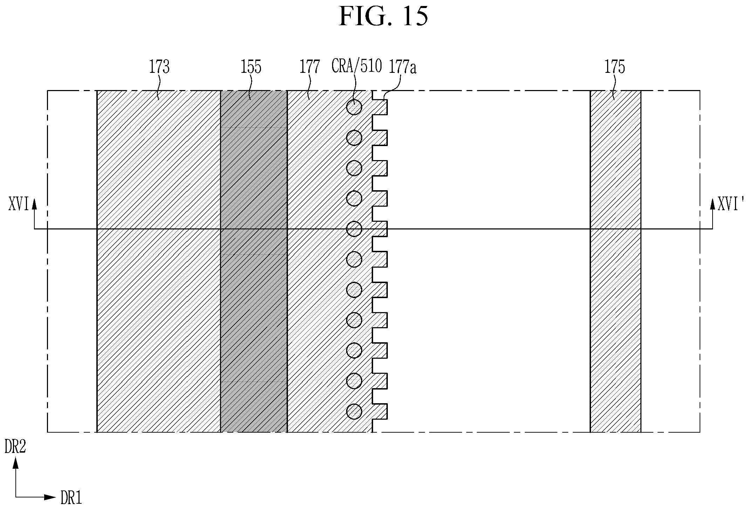

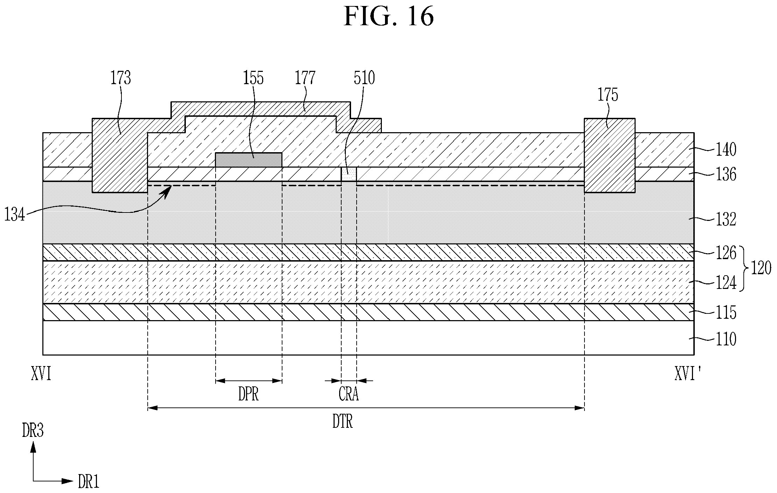

FIG. 15 is a plan view showing an example of a semiconductor device according to some implementations. FIG. 16 is a cross-sectional view shown along line XVI-XVI' in FIG. 15 according to some implementations.

Since elements shown in FIGS. 15 and 16 may be substantially the same as elements shown in FIGS. 1 and 4, description thereof will be omitted and the differences will be mainly explained. In addition, the same reference numerals are used for the same components as previous implementations. Elements shown in FIGS. 15 and 16 may be slightly different from previous implementations in that the channel suppression region does not overlap the protruding portion of the field dispersion layer.

In FIGS. 15 and 16, the channel suppression region CRA may be adjacent to the edge of the field dispersion layer 177 adjacent to the drain electrode 175. The channel suppression region CRA may be adjacent to the protruding portion 177a of the field dispersion layer 177. The channel suppression region CRA may overlap the field dispersion layer 177 in the third direction DR3, and may not overlap the protruding portion 177a of the field dispersion layer 177 in the third direction DR3.

In some implementations, at least a portion of the channel suppression region CRA may not be covered by the field dispersion layer 177, and in some implementations, the entire channel suppression region CRA may be covered by the field dispersion layer.

Accordingly, the doping region 510 of the barrier layer 136 may overlap the field dispersion layer 177 in the third direction DR3, and may not overlap the protruding portion 177a of the field dispersion layer 177 in the third direction DR3. The doping region 510 may be positioned closer to the gate electrode 155 in the first direction DR1 than the protruding portion 177a of the field dispersion layer 177. The entire doping region 510 of the barrier layer 136 may be covered by the field dispersion layer 177. As another example, similar to FIGS. 9 to 12, the recess 520, the channel suppression pattern 530, or the channel suppression pattern 540 may be used instead of the doping region 510.

In some implementations, the channel suppression region CRA may be formed by the doping region 510 of the barrier layer 136. However, it is not limited to this, and as described in previous implementations, the channel suppression region CRA may be formed by a recess formed in the barrier layer 136, a channel suppression pattern positioned on the barrier layer 136, etc. The channel suppression region CRA may be positioned closer to the gate electrode 155 in the first direction DR1 than the protruding portion 177a of the field dispersion layer 177.

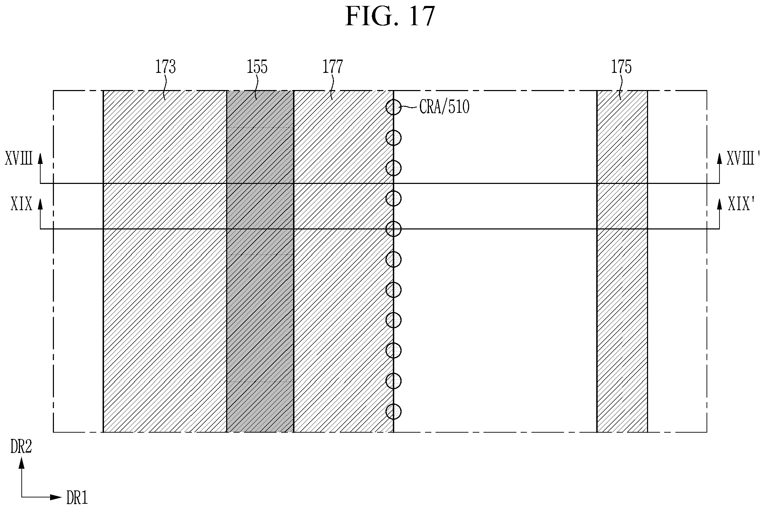

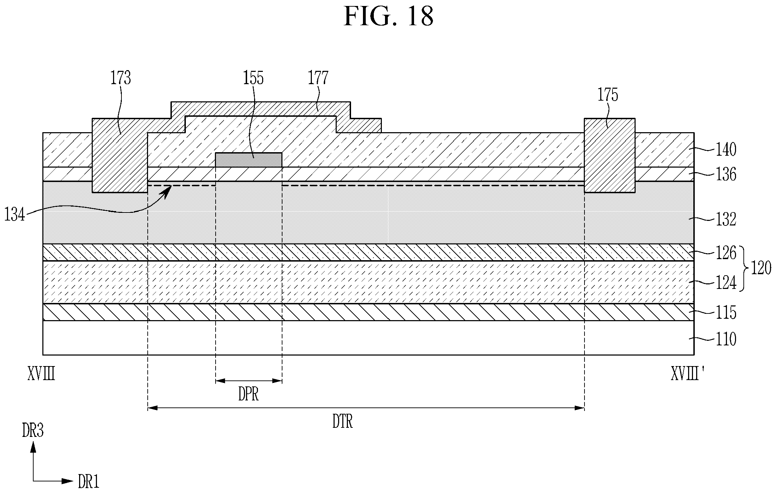

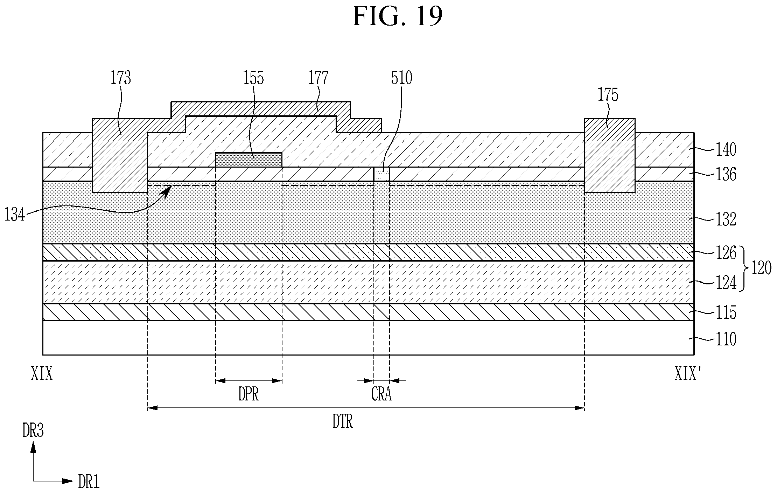

FIG. 17 is a plan view showing an example of a semiconductor device according to some implementations. FIG. 18 is a cross-sectional view shown along line XVIII-XVIII' in FIG. 17 according to some implementations. FIG. 19 is a cross-sectional view shown along line XIX-XIX' in FIG. 17 according to some implementations.

Since elements shown in FIGS. 17 to 19 may be substantially the same as elements shown in FIGS. 1 to 4, description thereof will be omitted and the differences will be mainly explained. In addition, the same reference numerals are used for the same components as previous implementations. FIGS. 17 to 19 may be slightly different from previous implementations in that the field dispersion layer does not include a protruding portion.

In FIGS. 17 to 19, the edge of the field dispersion layer 177 adjacent to the drain electrode 175 may be formed as a straight line. The edge of the field dispersion layer 177 adjacent to the drain electrode 175 may have a straight line shape parallel to the second direction DR2 on a plane.

In some implementations, the protruding portion 177a may be formed from the edge of the field dispersion layer 177, and in the present embodiment, the protruding portion 177a may not be formed at the edge of the field dispersion layer 177.

The edge of the field dispersion layer 177 adjacent to the drain electrode 175 may be adjacent to a channel suppression region CRA. The edge of the field dispersion layer 177 adjacent to drain electrode 175 may overlap the channel suppression region CRA in third direction DR3. The edge of the field dispersion layer 177 adjacent to the drain electrode 175 may be adjacent to the doping region 510 of the barrier layer 136. The edge of the field dispersion layer 177 adjacent to the drain electrode 175 may overlap the doping region 510 of the barrier layer 136 in the third direction DR3.

In some implementations, the channel suppression region CRA may be formed by the doping region 510 of the barrier layer 136. However, it is not limited to this, and as described in previous implementations, the channel suppression region CRA may be formed by a recess formed in the barrier layer 136, a channel suppression pattern positioned on the barrier layer 136, etc.

In some implementations, the gate semiconductor layer 152 may also be applied in which the gate semiconductor layer 152 is disposed between the gate electrode 152 and the barrier layer 136. For example, two of the doping region 510, the recess 520, the channel suppression pattern 530, and the channel suppression pattern 540 may be used together in the implementations described above. For example, in FIG. 4, a channel suppression pattern 530 may be formed on the doping region 510. At this time, at least some of the doping region 510 and the channel suppression pattern 530 may overlap in the third direction DR3. In some implementations, the doping region 510 and the channel suppression pattern 530 may not overlap in the third direction DR3. From a planar view, the doping region 510 and the channel suppression pattern 530 may be spaced apart in at least one direction among the first direction DR1 and the second direction DR2. Accordingly, at least one of the doping region 510 and the channel suppression pattern 530 may not overlap the protruding portion 177a of the field dispersion layer 177 in the third direction DR3. These examples may be similarly applied when using another two structures together among the structures (the doping region 510, the recess 520, the channel suppression pattern 530, and the channel suppression pattern 540) that form the channel suppression region CRA.

While this disclosure contains many specific implementation details, these should not be construed as limitations on the scope of what may be claimed. Certain features that are described in this disclosure in the context of separate implementations can also be implemented in combination in a single implementation. Conversely, various features that are described in the context of a single implementation can also be implemented in multiple implementations separately or in any suitable subcombination. Moreover, although features may be described above as acting in certain combinations, one or more features from a combination can in some cases be excised from the combination, and the combination may be directed to a subcombination or variation of a subcombination.

## Claims

1. A semiconductor device comprising:
a channel layer including a channel suppression region,
a barrier layer positioned above the channel layer, the barrier layer including a material having a different energy band gap from the channel layer,
a gate electrode positioned above the barrier layer,
a protective layer positioned above the gate electrode,
a source electrode and a drain electrode positioned on opposing sides of the gate electrode and connected to the channel layer, and
a field dispersion layer positioned above the protective layer, the field dispersion layer protruding from an edge adjacent to the drain electrode toward the drain electrode and including a protruding portion adjacent to the channel suppression region.

2. The semiconductor device of claim 1,
wherein the source electrode and the drain electrode are spaced apart from each other in a first direction,
wherein the gate electrode, the source electrode, and the drain electrode extend in a second direction intersecting the first direction, and
wherein the protruding portion overlaps the channel suppression region in a third direction perpendicular to the first and second directions.

3. The semiconductor device of claim 2,
wherein a length of the protruding portion along the first direction is 0.1 µm or more and 2µm or less, and
wherein a width of the protruding portion along the second direction is 0.05µm or more and 5µm or less.

4. The semiconductor device of claim 2 or 3,
wherein the barrier layer comprises a doping region that overlaps the channel suppression region in the third direction, and
wherein the doping region contains Ar or N.

5. The semiconductor device of any one of claims 2 to 4, wherein the channel suppression region overlaps in the third direction with a recess in at least a portion of the barrier layer.

6. The semiconductor device of any one of claims 2 to 5, further comprising a channel suppression pattern overlapping the channel suppression region in the third direction on the barrier layer.

7. The semiconductor device of claim 6, wherein the channel suppression pattern comprises pGaN.

8. The semiconductor device of claim 6 or 7, further comprising:
a gate semiconductor layer between the barrier layer and the gate electrode,
wherein the channel suppression pattern comprises:
a first layer; and
a second layer positioned above the first layer, and
wherein a first layer of the channel suppression pattern is positioned on a same layer as the gate semiconductor layer, and
wherein a second layer of the channel suppression pattern is positioned on a same layer as the gate electrode.

9. The semiconductor device of any one of claims 2 to 8,
wherein the channel layer comprises a plurality of channel suppression regions, and
wherein the field dispersion layer comprises a plurality of protruding portions corresponding to a plurality of channel suppression regions, respectively.

10. The semiconductor device of claim 9,
wherein the plurality of channel suppression regions are equally spaced apart from each other along the second direction, and
wherein the plurality of protruding portions are equally spaced apart from each other along the second direction.

11. The semiconductor device of any preceding claim,
wherein the source electrode and the drain electrode are spaced apart from each other in a first direction,
wherein the gate electrode, the source electrode, and the drain electrode extend in a second direction intersecting the first direction, and
wherein the channel suppression region is spaced apart from the protruding portion in the first direction and does not overlap the field dispersion layer.

12. The semiconductor device of claim 11, wherein: a separation distance between the channel suppression region and the protruding portion along the first direction is 0.5µm or less.

13. The semiconductor device of any preceding claim,
wherein the source electrode and the drain electrode are spaced apart from each other in a first direction,
wherein the gate electrode, the source electrode, and the drain electrode extend in a second direction intersecting the first direction, and
wherein the channel suppression region is spaced apart from the protruding portion in the first direction and overlaps the field dispersion layer.

14. The semiconductor device of any preceding claim, wherein the protruding portion comprises a planar shape of a quadrangle, a triangle, or a round.

15. The semiconductor device of any preceding claim, wherein the field dispersion layer is integrated with the source electrode and covers the upper surface of the gate electrode.

## Amended claims

### Amended claims in accordance with Rule 137(2) EPC.

1. A semiconductor device comprising:
a channel layer (132) including a channel suppression region (CRA),
a barrier layer (136) positioned above the channel layer (132), the barrier layer including a material having a different energy band gap from the channel layer,
a gate electrode (155) positioned above the barrier layer,
a protective layer (140) positioned above the gate electrode,
a source electrode (173) and a drain electrode (175) positioned on opposing sides of the gate electrode (155) and connected to the channel layer (132), and
a field dispersion layer (177) positioned above the protective layer (140), the field dispersion layer (177) protruding from an edge of the field dispersion layer adjacent to the drain electrode (175), toward the drain electrode (175) so as to include a protruding portion (177a) adjacent to the channel suppression region (CRA),
wherein the source electrode (173) and the drain electrode (175) are spaced apart from each other in a first direction (DR1),
the gate electrode (155), the source electrode, and the drain electrode extend in a second direction (DR2) intersecting the first direction, and
the protruding portion (177a) and the channel suppression region (CRA) overlap in the first direction (DR1) in a plan view or a third direction (DR3) in a plan view perpendicular to the first and second directions.

2. The semiconductor device of claim 1,
wherein the protruding portion (177a) overlaps the channel suppression region (CRA) in the third direction (DR3).

3. The semiconductor device of claim 2,
wherein a length of the protruding portion (177a) along the first direction (DR1) is 0.1µm or more and 2µm or less, and
wherein a width of the protruding portion (177a) along the second direction (DR2) is 0.05µm or more and 5µm or less.

4. The semiconductor device of claim 2 or 3,
wherein the barrier layer comprises a doping region (510) that overlaps the channel suppression region (CRA) in the third direction (DR3), and
wherein the doping region contains Ar or N.

5. The semiconductor device of any one of claims 2 to 4, wherein the channel suppression region (CRA) overlaps in the third direction (DR3) with a recess (520) in at least a portion of the barrier layer (136).

6. The semiconductor device of any one of claims 2 to 5, further comprising a channel suppression pattern (530, 540) overlapping the channel suppression region (CRA) in the third direction (DR3) on the barrier layer (136).

7. The semiconductor device of claim 6, wherein the channel suppression pattern (530, 540) comprises pGaN.

8. The semiconductor device of claim 6 or 7, further comprising:
a gate semiconductor layer (152) between the barrier layer (136) and the gate electrode (155),
wherein the channel suppression pattern (540) comprises:
a first layer (542); and
a second layer (544) positioned above the first layer, and
wherein the first layer (542) of the channel suppression pattern (540) is positioned on a same layer as the gate semiconductor layer (152), and
wherein the second layer (544) of the channel suppression pattern (540) is positioned on a same layer as the gate electrode (155).

9. The semiconductor device of any one of claims 2 to 8,
wherein the channel layer (132) comprises a plurality of channel suppression regions (CRA), and
wherein the field dispersion layer (177) comprises a plurality of protruding portions (177a) corresponding to a plurality of channel suppression regions (CRA), respectively.

10. The semiconductor device of claim 9,
wherein the plurality of channel suppression regions (CRA) are equally spaced apart from each other along the second direction (DR2), and
wherein the plurality of protruding portions (177a) are equally spaced apart from each other along the second direction (DR2).

11. The semiconductor device of claim 1,
wherein the channel suppression region (CRA) is spaced apart from the protruding portion (177a) in the first direction and does not overlap the field dispersion layer in the third direction.

12. The semiconductor device of claim 11, wherein: a separation distance (Dst) between the channel suppression region (CRA) and the protruding portion (177a) along the first direction (DR1) is 0.5µm or less.

13. The semiconductor device of claim 1,
wherein the source electrode (173) and the drain electrode (175) are spaced apart from each other in a first direction (DR1),
wherein the gate electrode (155), the source electrode, and the drain electrode extend in a second direction (DR2) intersecting the first direction, and
wherein the channel suppression region (CRA) is spaced apart from the protruding portion (177a) in the first direction (DR1) and overlaps the field dispersion layer (177).

14. The semiconductor device of any preceding claim, wherein the protruding portion (177a) comprises a planar shape of a quadrangle, a triangle, or a round.

15. The semiconductor device of any preceding claim, wherein the field dispersion layer (177) is integrated with the source electrode (173) and covers the upper surface of the gate electrode (155).
